# EUROPEAN PATENT SPECIFICATION

(11) **EP 2 595 462 B1**
(45) Date of publication and mention of the grant of the patent: **06.01.2021**
(21) Application number: 12007766.4
(22) Date of filing: 16.11.2012
(51) Int. Cl.: H05K 3/28

(54) **Layered composite circuit with integrated components which are accessible from outside**
Geschichtete Verbundstoffschaltung mit integrierten Komponenten, die von außen zugänglich sind
Circuit composite en couches à composants intégrés accessibles depuis l'extérieur

(30) Priority: 16.11.2011 DE 102011118734
(43) Date of publication of application: 22.05.2013
(73) Proprietor: Hofmann, Thomas, 93057 Regensburg (DE)
(72) Inventor: Hofmann, Thomas, 93057 Regensburg (DE)
(74) Representative: Diehl & Partner

(56) References cited:
- EP-A1- 1 075 169
- EP-A1- 1 626 284
- EP-A2- 2 112 872
- WO-A1-2008/132814
- DE-U1-202010 014 862
- JP-A- 2008 186 986
- US-A1- 2009 190 277
- US-A1- 2010 248 505
- US-B1- 6 445 592

## Description

The invention relates to composite circuit boards and electric and/or electronic assemblies making use of composite circuit boards. The invention relates in particular to composite circuit boards having cavities which are accessible or assemblable from outside.

In order to fasten and connect electric and/or electronic components, preferably plate-shaped carriers, referred to as circuit boards, made of an electrically insulating material are used which are coated on one or both sides with a structured thin metal layer. The structure of the metal layer serves to provide electric connections between components and contacts for enabling electric contact from outside. The circuit boards are often also of multi-layered construction including metal connecting structures between the insulating layers.

In order to increase the packing density of electric and/or electronic assemblies composed of circuit boards (hereinafter generally referred to as "circuits"), the use of miniaturized components, such as so-called surface-mounted, unwired components or devices (surface-mounted devices, SMD), flip-chip components or wafer level package or chip size package devices are known which can be fastened, through their contact surfaces, directly to the respective electric connections and enable an automatic and, if applicable, double-sided assembly of circuit boards.

So-called active multilayers (AML) are known for use in particularly aggressive and moist environments or environments which are subject to mechanical load. In these active multilayers, the devices of a circuit or subcircuit are surrounded by a frame of electrically insulating material, and the frame is embedded between the circuit board and a cover plate which is formed, if required, by another circuit board. In electric or electronic assemblies provided in such AML technology, the devices can be disposed in one layer or multiple layers. In order to form the frame, it is usually a plate-shaped fibreglass laydown or fabric into which epoxy resin or another resin has been introduced, also referred to as "prepreg", is used which has holes formed therein to receive or surround the devices. Instead of one single plate, the frame may also be composed of multiple superimposed plates. In prepreg plates the resin is in the so-called B-stage, i.e., in an intermediate state in which the resin is not yet finally cured. Curing of the resin is effected while the layered composite is pressed at a temperature above the glass transition temperature of the epoxy resin. This pressing step is hereinafter referred to as "hot pressing". During the pressing step, part of the resin flows out of the fibreglass sheet and fills the spaces around and in the devices. Instead of composing the frame fully of prepreg plates, it is also possible to provide base material plates therebetween which include the resin already in the finally cured state. Such a frame structure is used in particular to provide a cost-efficient framing of relatively high components.

Both, the electronic components and the circuit components included in the AML composite are finally hermetically sealed. This is not always desirable. For example, some circuits require access to specific points of the electric connection structure, such as contact surfaces for testing and adjustment purposes or unassembled component areas intended for later use, a fluid or sight contact connection to components from outside of the circuit, for example, for pressure, sound or light sensors or simply to provide an external connection option, for example, by means of plug-in connectors that are accessible from outside.

Patent application US 2010/0248505 A1 discloses a mounting of a connector adjacent to an edge of a populated printed circuit board. The connector comprises a sealed housing enclosing a cavity with contacts formed therein. The whole of the printed circuit board assembly is then molded, followed by part of the circuit board being removed to open the cavity in the connector and to provide access to the contacts in there from the edge of the board.

Patent application JP 2008 186986 A discloses a method for providing access to the wiring of a printed circuit board that is placed within the circuit board itself. The access is used for mounting a circuit component which size does not allow an integration within the printed circuit board. The method uses a barrier element enclosing a volume between the barrier element and the desired part of the wiring structure. After embedding the barrier element in the printed circuit board, a hole is formed through both, the upper side of the board and the barrier element, providing access to the wiring structure for mounting a circuit component.

It is thus desirable to provide a circuit with embedded components, wherein one or more of the components thereof are accessible from outside at the edge of the circuit, as well as a process of producing such a circuit.

Embodiments of such a process comprise the steps as disclosed in claim 1.

Such a process enables the production of circuit arrangements with embedded circuit components which are accessible from outside and not enclosed by the resin of the prepreg plates or the functional areas of which are not affected by the resin.

Embodiments of a corresponding circuit relate to a circuit arrangement as disclosed in claim 10.

It should be noted that the terms "comprising", "having" "including", "containing" and "with", as used in the present description and claims, as well as grammatical modifications of these terms, used to recite features are to be understood as non-limiting recitals of features, such as, for example, process steps, devices, portions, dimensions and the like, and exclude in no way the presence of other or additional features or arrays of other or additional features.

According to advantageous embodiments of the process, the prepreg plate or the stack of prepreg plates are/is placed on the first plate side such that the barrier element is received in an opening or recess formed in one of the prepreg plates or the prepreg plate stack.

According to further advantageous embodiments of the process, the barrier element is formed as container having at least one opening and is placed or fastened with this opening on the first plate side such that the edge enclosing the at least one opening forms either itself or together with a peripheral edge of the carrier plate a continuous closed line. According to embodiments of these process variants, the edge enclosing the at least one opening of the container may be placed or fastened in full on the first plate side of the carrier plate, which results into a resin-tight connection between the carrier plate and the barrier element. It is advantageous for the barrier element to be fastened at the edge enclosing the at least one opening to the first plate side by adhesion bonding or soldering, so that the processes commonly applied in circuit board assembly and, in particular, in SMD assembly can be employed and the barrier elements are prevented from being displaced prior to assembling the cover plate. In advantageous embodiments of the circuit arrangement the barrier element is furthermore fastened to the surface of the carrier plate which effectively prevents the barrier element from loosening during operation of the circuit arrangement and improves the mechanical strength of the barrier element, for example, in applications in which it has to perform supporting tasks. According to further advantageous embodiments of the circuit arrangement, the barrier element has the shape of a container which is placed with one opening on the carrier plate and has another opening which merges into an opening formed in the cover plate such that full access from outside of the circuit arrangement to a circuit component accommodated in the barrier element is enabled.

According to further advantageous embodiments of the process, prior to hot pressing, a hollow space in the volume defined between the barrier element and the first plate side is filled with a filler material, and, after hot pressing, the filler material is removed through the opening to the outside of the circuit arrangement. As a result, an intolerable deformation of the barrier element during hot pressing is prevented. In order to better stabilize the barrier element, the filler material may be a material which tends to expand when the arrangement is heated during hot pressing, so that the pressure produced in the volume between the barrier element and the first plate side prevents the barrier element from significantly deforming during the hot pressing step.

According to further embodiments of the process, the barrier element is preferably placed on the first plate side such that an electric terminal and/or electric connector and/or electric component and/or electronic component or sensor disposed on the first plate side is accommodated in the volume defined between the barrier element and the first plate side.

Further features of the invention are evident from the following description of embodiments in combination with the claims and the Figures. In the Figures, the same or similar elements are designated by the same or similar reference signs. It is pointed out that the invention is not limited to the described embodiments, but is defined by the scope of the attached claims. In particular, the individual features of the described embodiments may be realized in the embodiments of the invention in different number and combination as the examples described hereinafter. In the following description of an embodiment of the invention, reference is taken to the attached figures, wherein
- Figure 1: shows the production of a circuit arrangement with circuit components which are embedded in the arrangement and accessible from outside of the arrangement in a product stage of an initial production phase.
- Figure 2: schematically shows the production of the circuit arrangement in a product stage of a later production phase.
- Figure 3: shows the production of the circuit arrangement in a product stage of a still further production phase, and
- Figure 4: shows the production of the circuit arrangement in a product stage of a further production phase with circuit components accessible from outside.

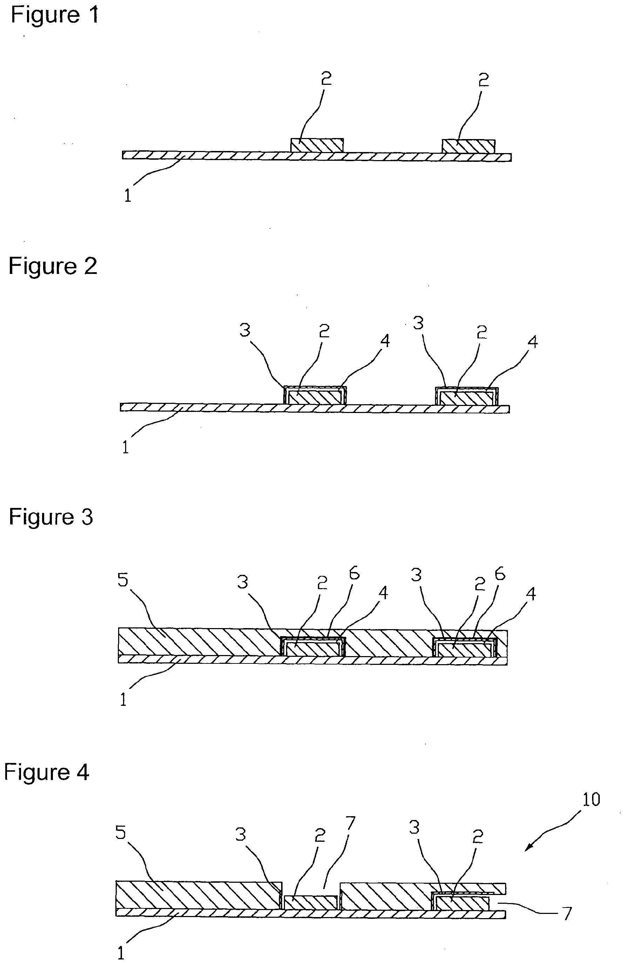

The schematic illustration of Figures 1 to 4 show a circuit structure in the different phases of a process for producing a circuit arrangement 10 with circuit components 2 which are embedded in the arrangement, but are nevertheless accessible from outside of the arrangement 10. The basis of the circuit arrangement 10 is formed by a plate-shaped carrier substrate 1, on one plate side of which - the upper plate side in Figures 1 to 4 - at least one circuit component 2 is mounted which, after the circuit arrangement 10 has been fully assembled, is accessible from outside of the circuit arrangement. The circuit component can, for example, be formed by a contact element of a conductive structure formed on the carrier plate 1, a plug connector component, a sensor, a display or display receiver, a battery holder or the like. In Figures 1 to 4 two circuit components 2 are disposed on the upper plate side of the carrier substrate 1, one in the central portion and another one in the peripheral portion of the carrier plate 1.

A circuit board 1 populated with the two circuit components 2 is schematically shown in Figure 1. In a subsequent production step each circuit component 2 is covered by a cap 3 as shown in Figure 2, the cap 3 being either placed or fastened so tightly on the carrier plate 1, either by adhesion bonding or soldering, that in the subsequent hot pressing step no resin can penetrate between cap 3 and carrier plate 1 into the volume surrounded by the two caps.

In the embodiment shown in Figure 1, the cap 3 is formed as a container open on one side, the opening of said container being completely covered by the carrier plate 1 when the cap 3 is placed on the carrier plate. As already stated, the cap 3 can be put over the circuit component 2 such that, as shown, a hollow space 4 is formed between the circuit component 2 and the inner surface of the cap 3, said hollow space 4 separating at least one surface area of the circuit component 2 from the cap 3. Preferably, the surface area of the circuit component 2, to which an access from the outside of the circuit component is to be provided, is spaced apart from the cap 3 in order for the circuit component 2 not to be damaged when a corresponding opening is introduced into the cap 3. If access to the circuit component 2 is provided by an opening to be introduced into the carrier plate, the cap 3 can also be formed such that no hollow space is formed between the inner wall of the cap and the outer surfaces of the circuit component 2. According to further embodiments, which differ from the embodiments described so far, the circuit components 2 and cap 3 are formed integrally such that circuit component 2 and cap 3 can be mounted on the carrier plate in one working step. Usually, an integrated design of circuit component 2 and cap 3 reduces the overall height.

As shown in Figure 3, in a subsequent step of the production process, a cover plate 5 is placed on the side of the circuit board 1 which is equipped with cap 3. The cover plate 5 includes openings or recesses for accommodating the cap 3. Usually, the cover plate 5 is comprised of a stack of plural plates which are each formed of a prepreg material. The lower plates of the stack disposed closer to the carrier plate 1 are formed with openings for receiving the cap 3, while usually one or more of the plates of the stack disposed above the caps 3 have a closed surface at least in the area of the caps 3. Caps which lie flush with the cover plate 5 are of course not covered by the cover plate. The cover plate 5 is connected with the carrier plate 1 by hot pressing. If a plate stack is used, as described above, for forming the cover plate, the hot pressing also bonds the plates of the stack together to form a cover plate 5. Epoxy resin escaping from the prepreg material during the hot pressing step fills the spaces 6 between the cover plate 5 and the caps 3, so that the hot pressing usually results into a hermitically sealed embedding of the caps 3 in the cover plate 5. As each cap forms a barrier against a penetration of epoxy resin into the volume enclosed by the cap 3 and the carrier plate 1, the resin is prevented from passing to the circuit components covered by the caps 3.

If use is made of very flat caps, the prepreg plates used for forming the cover plate 5 need not necessarily have openings or recesses, because resin escaping from the prepreg plate during hot pressing is displaced from the top of the cap and the fibreglass structure is compressed at this point such that a planar surface is formed.

In embodiments of the circuit arrangement 10 wherein a cap 3 covers on the surface plate 1 an area which, contiguous to an edge of the carrier plate 1, extends over the entire length of the edge, the respective recess in the cover plate 5 extends over the entire edge length and thus practically constitutes a shortened configuration of the cover plate in respect of the carrier plate 1. Such a shortening is in the present document subsumed under the term opening or recess.

In order to provide an access to the circuit components 2 covered by the caps 3 and to provide a circuit arrangement 10 as illustrated in Figure 4, openings 7 are formed in the circuit assembly in a step carried out in a production step after the hot pressing step, said openings 7 extending from an outer surface area of the circuit assembly through the cover plate 5 and the respective cap 3 into the volume enclosed by said cap 3 and the carrier plate 1. In the circuit arrangement 10 shown in Figure 4, the opening 7 extending to the circuit component 2 disposed in the central area of the carrier plate 1 extends from the upper surface of the cover plate 5 vertically down in the direction of the carrier plate 1 and into the interior of the cap 3 kept free from the resin of the prepreg material. As far as the circuit component 2 disposed in the peripheral area of the carrier plate 1 is concerned, the opening 7 extends from the contiguous side surface of the cover plate 5 parallel to the carrier plate 1 horizontally into the interior of the cap 3. The cross-sections of the openings 7 can be formed in correspondence with the respective inner dimensions of the cap, as illustrated in Figure 1. Depending on the individual application, they can also be larger or smaller or may have a shape which might differ from the inner or outer dimensions of the cap 3. The openings 7 are formed by usual techniques, such as milling, drilling or laser ablation.

In other embodiments, caps 3 are used which have a shape which differs from the above-described cap shape, for example, a prompt box shape, wherein not only the bottom but also one side of the cap 3 is open, so that when the cap is placed at the periphery of the carrier plate 1 a laterally accessible hollow space is formed and the step of opening of the hollow space after hot pressing is reduced to a trimming of the cap. These types of cavities that are open to a side edge of a circuit board are particularly suited for enclosing electrical connectors or connector elements designed for being connected with matching connectors by inserting the connectors in a direction perpendicular to the side edge of the circuit board. Examples of such connectors are for instance data bus connectors like USB sockets for receiving an USB plug, spring clip arrangements for receiving open connector strips of other circuit boards or for receiving cables as well as flat cable connectors. The connector may further be an optical connector. Cap 3 may be configured for guiding an external connector component into the proper position or a keying for preventing the external connector to be inserted the wrong way. Cap 3 may further be configured for providing a holding force preventing an inserted connector from being withdrawn unintentionally. Instead of using a prompt box shaped cap 3, also a cup like shaped cap 3 may be placed over the connector components at the peripheral area of the carrier plate 1. The cap may then be opened at the edge side of the circuit board by trimming the edge.

In special applications, for example, in order to provide a barrier at a side surface of the cover plate 5 to delimit the same against a peripheral edge portion of the carrier plate 1 which is open at the top, the "cap" can also be provided as a rib-shaped barrier element. A corresponding peripheral portion of the carrier plate which opens to the top and side is, for example, useful for plug connector components or battery holders. In order to prevent in such open cap configuration resin from penetrating into the volume to be kept free, the cap may be filled with a filler material, as will be described hereinafter.

The caps 3 are preferably formed of a material which does not tend to flow at the pressures and temperatures applied in hot pressing. For example, the caps 3 may be made of a duroplastic material, a thermoplastic material having a higher glass transition temperature than the prepreg material of the cover plate 5, i.e., a glass transition temperature of preferably 180°C or higher, or of another material, such as metal, ceramics or glass. During hot pressing, the caps may deform under certain circumstances. If this is not desired, or the deformation to be expected, in the case of very thin cap walls or caps 3 which are of large dimensions in relation to the wall thickness, is intolerable, a deformation can be counteracted in that a filler material is introduced into the hollow spaces enclosed by the caps. Suitable filler materials are, for example, lacquers or gels which, after the openings 7 have been formed, can be washed out by a suitable solvent. If use is made of porous or granular filler materials, a removal of the filler material after the openings have been formed may under certain circumstances be unnecessary. Generally, the removal of filler material after hot pressing can be dispensed with if it fills the spaces between component and cap without covering the surfaces of the component exposed after the opining of the cap. Suitable filler materials are also materials or compositions which expand under the pressing temperature applied and thus exert a sufficient counter pressure to the pressure applied from outside.

The caps 3 can be mounted manually or by means of an automated assembling process. For an automated assembly of the caps 3, in particular assembling processes are suitable as used for SMD assembling of circuit boards. Adhesives or solder pastes for fastening the caps 3 can be applied on the carrier plate 1 by means of a dispenser or a printing process. Curing of the adhesive or soldering of the caps can be effected together with the curing of the adhesion spots for fastening the components on the carrier plate 1 or the soldering of these components on the carrier plate. Instead of adhesion bonding or soldering, other fastening techniques may be applied as well, such as laser or ultrasonic welding.

According to embodiments, the caps 3 or some of the caps 3 are formed to cover or accommodate multiple circuit components 2 in one cap. The use of such caps offers itself, e.g., when a portion of an electric connection of the circuit 10 formed as test point or a plug connector component 2 shall be accessible from outside and a pressure sensor is in the vicinity of the test point which can thus be in fluid communication with the environment of the circuit without a separate opening.

Further, a cap 3 can also be used to define a hollow space in a circuit arrangement 10 which is formed for insertion of a circuit component into the circuit arrangement after the hot pressing step. Such a hollow space preparation offers itself, for example, for cases in which the circuit arrangement 10 to be formed includes components which are sensitive to the temperatures and pressures applied during hot pressing, e.g., displays or sensors operating with organic substances. In order to subsequently insert circuit components into the hollow spaces, caps 3 may be used which are specifically provided to perform supporting tasks, or, if required, also to provide an electric contact and/or, if required, a transparent cover of these circuit components. Any hollow spaces, which might remain after the circuit components have been inserted, can of course be filled, if required. A filling of a hollow space formed to receive further components with a preferably removable mass can, for example, be effected, if an insertion of the component is not effected during production, but is to be optionally enabled at a later point in time, for example, to extend the scope of function of the circuit arrangement 10. Instead of filling the hollow space, it can also be covered, for example, with a surface-flush cover, which, if required, is sealed in order to prevent dust or moisture from penetrating into the hollow space.

So far, the invention has been explained with reference to circuit arrangements 10 with only one circuit board 1. However, it is obvious to the skilled person that the invention can also be realized with complexer circuit arrangements 10, which include, for example, two or more or double-sided mounted carrier plates.

## Claims

1. A process for producing a circuit arrangement, comprising the following steps:
- placing a barrier element (3) on a first plate side of a carrier plate (1) comprising at least one circuit component (2) such that a volume is enclosed between the barrier element (3) and the first plate side,
- placing a prepreg plate or plural prepreg plates stacked upon each other on the first plate side,
- hot pressing the resulting arrangement,
wherein the barrier element (3) is placed in a peripheral area of the carrier plate (1), and said at least one circuit component (2) is accomondated in the volume enclosed between the barrier element (3) and the first plate side, and by a further step for
- forming an opening (7) from a side edge of the circuit arrangement (10) to the volume enclosed between the barrier element (3) and the first plate side.

2. The process according to claim 1, wherein the prepreg plate or the prepreg plate stack is placed on the first plate side such that the barrier element (3) is accommodated in an opening or recess formed in the prepreg plate or stack of prepreg plates located at the peripheral area of the carrier plate.

3. The process according to claim 1 or 2, wherein the barrier element (3) is configured as a container having at least one opening and is placed or fastened with this opening on the first plate side of the carrier plate (1) such that the edge enclosing the at least one opening as such or together with a peripheral edge of the carrier plate (1) define a closed continuous line.

4. The process according to claim 3, wherein the edge enclosing the at least one opening of the container (3) is completely placed or fastened on the first plate side of the carrier plate (1).

5. The process according to claim 3 or 4, wherein the barrier element (3) is fastened at the edge enclosing the at least one opening to the first plate side by adhesion bonding or soldering.

6. The process according to claims 1 to 5, wherein the barrier element (3) has a prompt box shape, with its side opening located at the side edge of the carrier plate (1).

7. The process according to claims 1 to 6, wherein, prior to hot pressing, a hollow space (4) in the volume enclosed between the barrier element (3) and the first plate side is filled with filler material, and the filler material is removed after hot pressing through the opening to the outside of the circuit arrangement.

8. The process according to claim 7, wherein a material is used as filler material which tends to expand when the assembly is heated during the hot pressing step such that pressure resulting in the volume enclosed between the barrier element (3) and the first plate side prevents the barrier element (3) from being significantly deformed during hot pressing.

9. The process according to one of claims 1 to 8, wherein the barrier element (3) is placed on the first plate side such that an electric terminal and/or an electric connector and/or an optical connector placed on the first plate side is accommodated in the volume enclosed between the barrier element and the first plate side such, that the electric terminal and/or electric connector and/or optical connector are accessible from the side edge of the circuit arrangement.

10. A circuit arrangement comprising a carrier plate (1), a cover plate (5) placed thereon, and a barrier element (3), wherein said cover plate (5) has a hollow space with an opening (7) to the outside of the circuit arrangement (10), and the barrier element (3) is positioned within the hollow space,
wherein the opening (7) of the hollow space of the cover plate (5) and the barrier element are both open to a side edge of the circuit arrangement (10) and **characterised in that** the barrier element is configured such that a volume is enclosed between the barrier element (3) and a side of the carrier plate (1) which accommodates the circuit component (2) disposed on said side of the carrier plate (1).

11. The circuit arrangement according to claim 10, wherein the barrier element (3) is fastened to the surface of the carrier plate (1).

12. The circuit arrangement according to claim 10 or 11, wherein the barrier element (3) encloses a connector or connector element and has the shape of a prompt box configured for receiving a connector component adapted for connection with the enclosed connector or connector component from the side edge of the circuit arrangement.

## Patentansprüche

1. Verfahren zur Herstellung einer Schaltungsanordnung, das folgende Schritte umfasst:
- Anordnen eines Barriereelements (3) auf einer wenigstens eine Schaltungskomponente (2) aufweisenden ersten Plattenseite einer Trägerplatte (1) so, dass zwischen dem Barriereelement (2) und der ersten Plattenseite ein Volumen umgrenzt wird,
- Anordnen von einer Prepregplatte oder von mehreren übereinander gestapelten Prepregplatten auf der ersten Plattenseite, und
- Heißverpressen der so erstellten Anordnung,
wobei das Barriereelement (3) an einem Randbereich der Trägerplatte (1) angeordnet ist, und das wenigstens eine Schaltungskomponente (2) in einem zwischen dem Barriereelement (3) und der ersten Plattenseite umgrenzten Volumen aufgenommen ist, und durch einen weiteren Schritt für
- Ausbilden einer Öffnung (7) von einer Außenseite der Schaltungsanordnung (10) zu dem zwischen dem Barriereelement (3) und der ersten Plattenseite umgrenzten Volumen.

2. Verfahren nach Anspruch 1, wobei die Prepregplatte oder der Stapel von Prepregplatten so auf der ersten Plattenseite angeordnet werden, dass das Barriereelement (3) in einer in der Prepregplatte oder dem Prepregplattenstapel ausgebildeten Ausnehmung oder Aussparung aufgenommen ist.

3. Verfahren nach Anspruch 1 oder 2, wobei das Barriereelement (3) als wenigstens eine Öffnung aufweisender Behälter ausgebildet ist und mit dieser Öffnung so auf die erste Plattenseite der Trägerplatte (1) aufgelegt oder darauf befestigt wird, dass der die wenigstens eine Öffnung umgrenzende Rand selbst oder zusammen mit einer Randbegrenzung der Trägerplatte (1) eine in sich geschlossene Linie bildet.

4. Verfahren nach Anspruch 3, wobei der die wenigstens eine Öffnung des Behälters (3) umgrenzende Rand vollständig auf der ersten Plattenseite der Trägerplatte (1) aufgelegt oder befestigt wird.

5. Verfahren nach Anspruch 3 oder 4, wobei das Barriereelement (3) an dessen wenigstens eine Öffnung umgrenzenden Rand an der ersten Plattenseite durch Kleben oder Löten befestigt wird.

6. Verfahren nach einem der Ansprüche 1 bis 5, wobei das Barriereelement (3) eine souffleurkastenförmige Gestalt besitzt, wobei die seitige Öffnung an dem Seitenrand der Trägerplatte (1).

7. Verfahren nach einem der Ansprüche 1 bis 6, wobei vor dem Heißverpressen ein in dem zwischen dem Barriereelement (3) und der ersten Plattenseite umgrenzten Volumen befindlicher Leerraum (4) mit einem Füllmaterial gefüllt und das Füllmaterial nach dem Heißverpressen über die Öffnung zur Außenseite der Schaltungsanordnung entfernt wird.

8. Verfahren nach Anspruch 7, wobei als Füllmaterial ein Material verwendet wird, das sich bei Erwärmung der Anordnung während des Heißverpressens so zum Ausdehnen tendiert, dass der hierbei im zwischen Barriereelement (3) und erster Plattenseite umgrenzten Volumen erzeugte Druck einer signifikanten Verformung des Barriereelements (3) während des Heißverpressens vorbeugt.

9. Verfahren nach einem der Ansprüche 1 bis 8, wobei das Barriereelement (3) so auf der ersten Plattenseite angeordnet wird, dass in dem zwischen dem Barriereelement und der ersten Plattenseite umgrenzten Volumen ein an der ersten Plattenseite angeordnetes elektrisches Anschlusselement und/oder elektrisches Verbindungselement und/oder elektrisches Bauelement und/oder elektronisches Bauelement und oder Sensor aufgenommen ist.

10. Schaltungsanordnung umfassend eine Trägerplatte (1), einer darauf angeordneten Abdeckplatte (5) und einem Barriereelement (3), wobei die Abdeckplatte (5) einen Hohlraum aufweist, der eine Öffnung (7) zu einer Außenseite der Schaltungsanordnung (10) aufweist und das Barriereelement (3) innerhalb des Hohlraums angeordnet ist, wobei die Öffnung (7) des Hohlraums der Abdeckplatte (5) und das Barriereelement beide zu einem Seitenrand der Schaltungsordnung offen sind und
**dadurch gekennzeichnet, dass** das Barriereelement so konfiguriert ist, dass ein Volumen zwischen dem Barriereelement (3) und einer Seite der Trägerplatte (1) umgrenzt ist, welches die Schaltungskomponente (2) aufnimmt, die auf der Seite der Trägerplatte angeordnet ist.

11. Schaltungsanordnung nach Anspruch 10, wobei das Barriereelement (3) an der Oberfläche der Trägerplatte (1) befestigt ist.

12. Schaltungsanordnung nach Anspruch 10 oder 11, wobei das Barriereelement (3) einen Verbinder oder eine Verbinderkomponente umgrenzt und eine souffleurkastenförmige Gestalt besitzt, die so konfiguriert, um eine Verbinderkomponente aufzunehmen, die zur Verbindung mit dem umgrenzten Verbinder oder der Verbinderkomponente von dem Seitenrand der Schaltungsanordnung.

## Revendications

1. Procédé pour produire un arrangement de circuit, comprenant les étapes suivantes :
- placer un élément barrière (3) sur un premier côté de plaque d'une plaque de support (1) comprenant au moins un composant de circuit (2) de telle sorte qu'un volume soit enfermé entre l'élément barrière (3) et le premier côté de plaque,
- placer une plaque de préimprégné ou plusieurs plaques de préimprégné empilées les unes sur les autres sur le premier côté de plaque, et
- presser à chaud l'arrangement obtenu,
dans lequel l'élément barrière (3) est placé dans une zone périphérique de la plaque de support (1), et ledit au moins un composant de circuit (2) est logé dans le volume enfermé entre l'élément barrière (3) et le premier côté de plaque, et par une étape supplémentaire pour
- former une ouverture (7) depuis un bord latéral de l'arrangement de circuit (10) jusqu'au volume enfermé entre l'élément barrière (3) et le premier côté de plaque.

2. Procédé selon la revendication 1, dans lequel la plaque de préimprégné ou l'empilement de plaques de préimprégné est placé sur le premier côté de plaque de telle sorte que l'élément barrière (3) soit logé dans une ouverture ou un creux formé dans la plaque de préimprégné ou l'empilement de plaques de préimprégné situé sur la zone périphérique de la plaque de support (1).

3. Procédé selon la revendication 1 ou 2, dans lequel l'élément barrière (3) est configuré comme un contenant ayant au moins une ouverture et est placé ou fixé avec cette ouverture sur le premier côté de plaque de la plaque de support (1) de telle sorte que le bord enfermant la au moins une ouverture en tant que tel ou conjointement avec un bord périphérique de la plaque de support (1) définisse une ligne continue fermée.

4. Procédé selon la revendication 3, dans lequel le bord enfermant la au moins une ouverture du contenant (3) est complètement placé ou fixé sur le premier côté de plaque de la plaque de support (1).

5. Procédé selon la revendication 3 ou 4, dans lequel l'élément barrière (3) est fixé, au bord enfermant la au moins une ouverture, au premier côté de plaque par liaison par adhésion ou par soudage.

6. Procédé selon les revendications 1 à 5, dans lequel l'élément barrière (3) a une forme de bouton d'assistance, avec son ouverture latérale située au bord latéral de la plaque de support (1).

7. Procédé selon les revendications 1 à 6, dans lequel avant le pressage à chaud, un espace creux (4) dans le volume enfermé entre l'élément barrière (3) et le premier côté de plaque est rempli avec un matériau de remplissage, et le matériau de remplissage est enlevé après le pressage à chaud à travers l'ouverture vers l'extérieur de l'arrangement de circuit.

8. Procédé selon la revendication 7, dans lequel un matériau est utilisé comme matériau de remplissage qui a tendance à se dilater quand l'ensemble est chauffé pendant l'étape de pressage à chaud de telle sorte que la pression apparaissant dans le volume enfermé entre l'élément barrière (3) et le premier côté de plaque empêche l'élément barrière (3) d'être significativement déformé pendant le pressage à chaud.

9. Procédé selon l'une des revendications 1 à 8, dans lequel l'élément barrière (3) est placé sur le premier côté de plaque de telle sorte qu'une borne électrique et/ou un connecteur électrique et/ou un connecteur optique placé sur le premier côté de plaque soit logé dans le volume enfermé entre l'élément barrière et le premier côté de plaque, de sorte que la borne électrique et/ou le connecteur électrique et/ou le connecteur optique soient accessibles depuis le bord latéral de l'arrangement de circuit.

10. Arrangement de circuit comprenant une plaque de support (1), une plaque de recouvrement (5) placée sur elle et un élément barrière (3), dans lequel ladite plaque de recouvrement (5) a un espace creux avec une ouverture (7) vers l'extérieur de l'arrangement de circuit (10), et l'élément barrière (3) est positionné à l'intérieur de l'espace creux, dans lequel l'ouverture (7) de l'espace creux de la plaque de recouvrement (5) et l'élément barrière sont tous les deux ouverts vers un bord latéral de l'arrangement de circuit (10) et **caractérisé en ce que** l'élément barrière est configuré de telle sorte qu'un volume soit enfermé entre l'élément barrière (3) et un côté de la plaque de support (1) qui loge le composant de circuit (2) disposé sur ledit côté de la plaque de support (1).

11. Arrangement de circuit selon la revendication 10, dans lequel l'élément barrière (3) est fixé à la surface de la plaque de support (1).

12. Arrangement de circuit selon la revendication 10 ou 11, dans lequel l'élément barrière (3) enferme un connecteur ou élément de connecteur et a la forme d'un bouton d'assistance configuré pour recevoir un composant de connecteur adapté pour la connexion avec le connecteur ou le composant de connecteur enfermé depuis le bord latéral de l'arrangement de circuit.
